# EUROPÄISCHE PATENTSCHRIFT

(11) **EP 1 673 810 B1**
(45) Veröffentlichungstag und Bekanntmachung des Hinweises auf die Patenterteilung: **25.02.2009**
(21) Anmeldenummer: 04766814.0
(22) Anmeldetag: 16.09.2004
(51) Int. Cl.: H01L 29/78, H01L 29/49, H01L 27/108, H01L 21/336, H01L 21/8242, H01L 29/51, H01L 29/161

(54) **FELDEFFEKTTRANSISTOR, INSBESONDERE VERTIKALER FELDEFFEKTTRANSISTOR, SPEICHERZELLE UND HERSTELLUNGSVERFAHREN**
FIELD EFFECT TRANSISTOR, PARTICULARLY VERTICAL FIELD EFFECT TRANSISTOR, MEMORY CELL, AND PRODUCTION METHOD
TRANSISTOR A EFFET DE CHAMP, NOTAMMENT TRANSISTOR A EFFET DE CHAMP VERTICAL, CELLULE DE MEMOIRE ET PROCEDE DE FABRICATION

(30) Priorität: 15.10.2003 DE 10348006
(43) Veröffentlichungstag der Anmeldung: 28.06.2006
(73) Patentinhaber: Infineon Technologies AG, 81669 München (DE)
(72) Erfinder: TEWS, Helmut, 81549 München (DE)
(74) Vertreter: Kindermann, Peter
(86) Internationale Anmeldenummer: PCT/EP2004/052216
(87) Internationale Veröffentlichungsnummer: WO 2005/038922

(56) Entgegenhaltungen:
- DE-A1- 10 301 939
- US-A- 5 561 308
- US-A1- 2003 057 491
- US-B1- 6 391 705
- MUSSIG H-J ET AL: "Can praseodymium oxide be an alternative high-K gate dielectric material for silicon integrated circuits?" INTEGRATED RELIABLILTY WORKSHOP FINAL REPORT, 2001. 2001 IEEE INTERNATIONAL OCT 15-18, 2001, PISCATAWAY, NJ, USA,IEEE, 15. Oktober 2001 (2001-10-15), Seiten 1-10, XP010587745 ISBN: 0-7803-7167-4

## Beschreibung

Die Erfindung betrifft einen Feldeffekttransistor mit:
- einem Kanalbereich,
- an den Kanalbereich angrenzenden elektrisch leitfähigen Kanalanschlussbereichen,
- einem an den Kanalbereich angrenzenden Transistordielektrikum, und
- einem vom Kanalbereich durch das Transistordielektrikum getrennten Steuerbereich.

Der Kanalbereich wird üblicherweise in einem Halbleitermaterial ausgebildet, d.h. in einem Material, dessen spezifischer Widerstand zwischen dem der Metalle und dem der Isolatoren liegt, d.h., der Werte zwischen etwa 10⁻⁴ und 10⁺¹² Ωcm hat. Außerdem wird der Kanalbereich meist in einem einkristallinen Material ausgebildet, um Transistoren mit guten Schalteigenschaften zu erhalten, insbesondere mit kleinen Leckströmen im Sperrzustand.

Die Kanalanschlussbereiche werden üblicherweise als Source bzw. Drain bezeichnet und sollen zu einem möglichst niederohmigen Anschluss des Kanalbereichs dienen. Beispielsweise enthalten die Kanalanschlussbereiche hochdotiertes Halbleitermaterial, dessen spezifischer Widerstand durch die Dotierung um mehrere Größenordungen verringert wird.

Als Dielektrikum werden Isoliermaterialien eingesetzt, beispielsweise Siliziumdioxid oder Materialien, deren relative Dielektrizitätskonstante erheblich größer ist als die Dielektrizitätskonstante von Siliziumdioxid.

Der Steuerbereich wird auch als Gate bezeichnet. Üblicherweise wird der Steuerbereich aus einem Metall oder aus polykristallinem Silizium gefertigt.

Die Feldeffekttransistoren lassen sich beispielsweise in planare Feldeffekttransistoren und vertikale Feldeffekttransistoren einteilen. Bei planaren Feldeffekttransistoren wird der Kanalbereich parallel zu einer Substratoberfläche ausgebildet, die eine Vielzahl von elektronischen Halbleiterbauelementen enthält, insbesondere von aktiven Bereichen dieser Bauelemente. Bei vertikalen Feldeffekttransistoren wird der Kanalbereich quer und insbesondere senkrecht zu dieser Substratoberfläche ausgebildet, wobei der Stromfluss im Kanalbereich entweder ebenfalls senkrecht zu der Substratoberfläche oder parallel zu der Substratoberfläche liegt. Bisher wird davon ausgegangen, dass bei einem einkristallinen Kanalbereich ein Steuerbereich aus einem polykristallinen Halbleitermaterial oder aus einem Metall ausreichend ist, da über den Steuerbereich nur eine Steuerspannung angelegt wird. Deshalb spielt der Stromfluss bezüglich des Steuerbereiches nur eine untergeordnete oder keine Rolle. Diese Herangehensweise führt zu Einschränkungen beim Design der integrierten Schaltungsanordnung.

Diese Nachteile werden insbesondere bei Feldeffekttransistoren für Speicherzellen deutlich. So werden bei flüchtig speichernden Speichereinheiten mit einer Vielzahl von Speicherzellen vertikale Feldeffekttransistoren in Gräben für Kondensatoren angeordnet, vgl. beispielsweise US 6,391,705 B1. Probleme aus der bisher üblichen Herangehensweise ergeben sich insbesondere:
- im Zusammenhang mit sogenannten buried straps, d.h. im Graben vergrabenen Anschlussbereichen, beispielsweise hinsichtlich der damit verbundenen Leckströme und hinsichtlich der zur Herstellung erforderlichen Herstellungsschritte,
- hinsichtlich des Platzbedarfs bei der Anordnung benachbarter Transistoren, und
- bezüglich von sogenannten Floating-Body-Effekten.

Aus der US 2003/0057491 A1 sind planare Feldeffekttransistoren bekannt, die von einem Glassubstrat, einem SOI-Substrat oder einem einkristallinen Substrat getragen werden und die jeweils einen einkristallinen Steuerbereich haben. Aus der US 5,561,308 ist ein DRAM mit Speicherzellen bekannt, die jeweils einen Dünnfilmtransistor und einen Grabenkondensator enthalten, wobei der Graben in einem Substrat ausgebildet ist, das ein Vielzahl von Halbleiterbauelementen trägt.

Es ist Aufgabe der Erfindung, einen einfach aufgebauten und einfach herzustellenden Feldeffekttransistor anzugeben, der insbesondere neue Freiheitsgrade für das Schaltungsdesign integrierter Schaltungen eröffnet und der insbesondere die einfache Herstellung von integrierten Speicherzellen ermöglicht. Außerdem sollen eine Speicherzelle und ein Herstellungsverfahren angegeben werden.

Die auf den Feldeffekttransistor bezogene Aufgabe wird durch einen Feldeffekttransistor mit den im Patentanspruch 1 angegebenen Merkmalen gelöst. Weiterbildungen sind in den Unteransprüchen angegeben.

Bei dem erfindungsgemäßen Feldeffekttransistor wird der Steuerbereich aus einkristallinem Material gefertigt. Damit lässt sich der Steuerbereich ohne weiteres in einem einkristallinen Halbleitersubstrat anordnen, wo bisher der Kanalbereich angeordnet worden ist. Außerdem ist es möglich, ausgehend von einem einkristallinen Material für den Steuerbereich ein einkristallines Dielektrikum epitaktisch aufzuwachsen. Anschließend lässt sich noch ein einkristalliner Kanalbereich auf das Dielektrikum epitaktisch aufzuwachsen. Es entsteht in diesem Fall ein "einkristalliner" Feldeffekttransistor, der sehr gute elektrische Eigenschaften hat. Bei einer Weiterbildung ist der einkristalline Steuerbereich in einem einkristallinen Substrat angeordnet, das vorzugsweise eine Vielzahl von elektrischen Halbleiterbauelementen trägt.

Bei einer anderen Weiterbildung enthält das einkristalline Substrat einen Graben, in dem das Dielektrikum und der Kanalbereich angeordnet sind. Der Steuerbereich ist vorzugsweise an einer Grabenwand angeordnet. Innerhalb eines Grabens werden bei einer Ausgestaltung mehrere Feldeffekttransistoren angeordnet, z.B. zwei Feldeffekttransistoren. Der Flächenbedarf für einen Feldeffekttransistor ist dann besonders klein, wenn ein Kanalanschlussbereich näher am Grabenboden als der andere Kanalanschlussbereich angeordnet ist, wie es bei vertikalen Transistoren mit vertikalem Stromfluss der Fall ist.

Das einkristalline Material, das den Steuerbereich enthält, ist bei einer Weiterbildung ein Halbleitermaterial, insbesondere ein dotiertes Halbmaterial. Geeignete Materialien sind insbesondere Silizium oder Siliziumgermanium.

Bei einer nächsten Weiterbildung ist auch das Transistordielektrikum einkristallin ausgebildet. Bei einer Ausgestaltung weicht die Gitterkonstante des einkristallinen Transistordielektrikums um weniger als ± 5 % bzw. um weniger als ± 3 % von der Gitterkonstante des einkristallinen Materials ab, das den Steuerbereich enthält. Durch diese Maßnahme lässt sich das Transistordielektrikum epitaktisch auf das einkristalline Material aufbringen, ohne dass störende Kristallbaufehler auftreten, beispielsweise Versetzungen. Geeignete Materialien für das Transistordielektrikum bei einem einkristallinen Material aus Silizium sind beispielsweise Cerdioxid (CeO₂) oder Praseodymoxid, insbesondere Praseodymtrioxid (Pr₂O₃).

Im Zusammenhang mit dem Aufwachsen von epitaktischen Praseodymoxidschichten auf einkristallines Silizium wird auf die beiden folgenden Artikel verwiesen:
- "Epitaxial growth of Pr2O3 on Si(111) and the observation of a hexagonal to cubic phase transition during postgrowth N2 Annealing" J.P. Liu, u.a., Applied Physics Letters, Band 79 (2001), Nr. 5, Seiten 671 bis 673, und
- "Epitaxial, high-K dielectrics on silicon: the example of praseodymium oxide", H.J . Osten, u.a., Microelectronics Reliability, Band 41 (2001), Seiten 991 bis 994.

Bei einer nächsten Weiterbildung des erfindungsgemäßen Feldeffekttransistors enthält auch der Kanalbereich einkristallines Material bzw. besteht aus einkristallinem Material. Damit lässt sich der Kanalbereich epitaktisch auf ein einkristallines Dielektrikum aufwachsen. Im Zusammenhang mit dem epitaktischen Aufbringen von Silizium auf ein einkristallines Dielektrikum, insbesondere auf ein Dielektrikum aus Praseodymoxid wird auf die eben genannten beiden Fachartikel verwiesen. Der Kanalbereich lässt sich dotieren. Jedoch wird der Kanalbereich insbesondere bei Abmessungen im Nanometerbereich auch undotiert ausgeführt. Bei einer Ausgestaltung hat der Kanalbereich quer zum Steuerbereich eine Ausdehnung kleiner als 20 nm. Durch diese Maßnahme entsteht ein sogenannter vollverarmter Feldeffekttransistor (fully depleted), bei dem sogenannte Kurzkanaleffekte nicht oder nur stark vermindert auftreten. Die elektrischen Eigenschaften des Feldeffekttransistors sind deshalb besonders gut.

Die Erfindung betrifft außerdem eine Speicherzelle, die den erfindungsgemäßen Feldeffekttransistor oder eine seiner Weiterbildungen enthält. Damit gelten die oben genannten technischen Wirkungen auch für die Speicherzelle. Die Speicherzelle ist insbesondere eine DRAM-Speicherzelle (Dynamic Random Access Memory).

Bei einer Weiterbildung der Speicherzelle ist der Feldeffekttransistor an einem Graben angeordnet, der ein Kondensatordielektrikum und eine Elektrode eines Grabenkondensators der Speicherzelle enthält. Bei einer nächsten Weiterbildung der Speicherzelle sind das Kondensatordielektrikum und die eine Elektrode des Grabenkondensators in einem unteren Teil des Grabens angeordnet. In einem oberen Teil des Grabens sind das Transistordielektrikum und der Kanalbereich angeordnet.

Bei einer nächsten Ausgestaltung ist der Kanalbereich entlang des Umfangs oder eines Teil des Umfangs des oberen Grabenteils angeordnet. Der Kanalbereich umschließt ein im Inneren des oberen Grabenteils angeordnetes dielektrisches Füllmaterial. Durch das Füllmaterial lässt sich die für den Stromfluss zur Verfügung stehende Stromtiefe begrenzen, so dass insbesondere ein sogenannter vollverarmter Feldeffekttransistor entsteht.

Bei einer anderen Weiterbildung enthält die Speicherzelle keinen Isolationskragen, so dass die damit verbundenen Herstellungsschritte entfallen können. Jedoch wird alternativ ein Isolationskragen ausgebildet, um das Entstehen von parasitären Transistoren zu unterbinden, falls keine anderen Maßnahmen getroffen sind.

Bei einer nächsten Weiterbildung ist der eine Kanalanschlussbereich innerhalb des Grabens elektrisch leitfähig mit einer Elektrode des Kondensators verbunden. Dies bedeutet, dass der Graben keinen sogenannten "buried strap" enthält. Damit entfallen die mit dem "buried strap" verbundenen Herstellungsschritte. Außerdem entfallen die mit dem "buried strap" verbundenen Leckströme.

Die Erfindung betrifft außerdem ein Verfahren zur Herstellung eines erfindungsgemäßen Feldeffekttransistors oder einer seiner Weiterbildungen bzw. zur Herstellung einer erfindungsgemäßen Speicherzelle bzw. ihrer Weiterbildungen. Damit gelten die oben genannten technischen Wirkungen auch für das Verfahren. Das Verfahren ist dann besonders einfach, wenn auf einem einkristallinen Bereich für den Steuerbereich zunächst das Transistordielektrikum epitaktisch aufgewachsen und danach auf das Transistordielektrikum der Kanalbereich epitaktisch aufgewachsen wird.

Im Folgenden werden Ausführungsbeispiele der Erfindung an Hand der beiliegenden Zeichnungen erläutert. Darin zeigen:

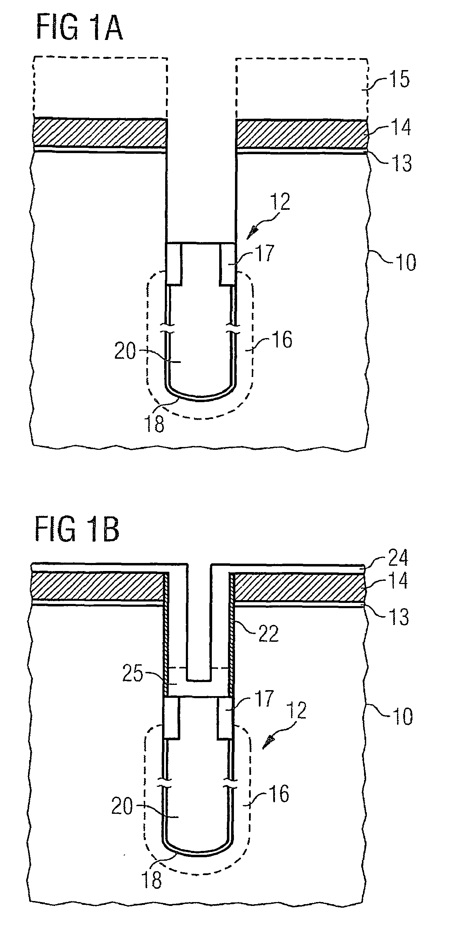

- Figuren 1A bis 1D: Herstellungsstufen bei der Herstellung einer DRAM-Speicherzelle.

Wie in Figur 1A dargestellt, wird ausgehend von einem Siliziumsubstrat 10 ein Verfahren zur Herstellung einer Vielzahl von tiefen Gräben in bekannter Weise ausgeführt, dabei wird unter anderem ein Graben 12 erzeugt. Der Graben 12 hat beispielsweise eine Tiefe, die zwischen 6 µm und 10 µm liegt. Der Durchmesser des Grabens beträgt beispielsweise weniger als 250 nm (Nanometer). In den Figuren 1A bis 1D wird der Graben 12 stark verkürzt dargestellt.

Beispielsweise wird zur Herstellung des Grabens 12 auf das Substrat 10 eine dünne Unterlageschicht 13 aufgebracht, beispielsweise eine Siliziumoxidschicht mit einer Dicke von 5 nm. Auf diese dünne Unterlageschicht 13 wird eine dazu im Vergleich dickere Unterlageschicht 14 aufgebracht, beispielsweise eine Siliziumnitridschicht mit einer Dicke von 100 nm bis 200nm. Auf die Unterlageschicht 14 wird eine Hartmaskenschicht 15 aufgebracht, beispielsweise aus TEOS (Tetraethylorthosilikat). Die Hartmaskenschicht 15 hat beispielsweise eine Dicke größer als 500 nm. Die Hartmaskenschicht 15, die Unterlageschicht 14 und die dünne Unterlageschicht werden mit Hilfe eines fotolithografischen Verfahrens strukturiert. Danach wird der Graben 12 unter Verwendung der aus der Hartmaskenschicht 15 entstandenen Hartmaske in das Substrat 10 geätzt, wobei bekannte Ätzverfahren genutzt werden.

Anschließend wird die Hartmaskenschicht 15 entfernt. Gegebenenfalls wird der Graben 12 vor oder nach dem Entfernen der Hartmaskenschicht 15 in seinem unteren Bereich aufgeweitet, insbesondere flaschenförmig (bottle process).

Es folgt ein optionaler Oberflächenbehandlungsprozess, bei dem beispielsweise die Rauheit der Oberfläche des Grabens 12 erhöht wird, beispielsweise mit Hilfe eines bekannten HSG-Verfahrens (HemiSpherical Growth), bei dem halbkugelförmige Siliziumkörner am Grabenboden und an der Grabenwand des Grabens 12 abgeschieden werden.

Anschließend werden mit Hilfe eines bekannten Verfahrens der Grabenboden und die Seitenwände im unteren Teil des Grabens 12 dotiert, wobei eine untere Elektrode 16 entsteht. Danach wird gemäß dem bekannten Verfahren ein Isolationskragen 17 im oberen Bereich des Grabens 12 und ein Kondensatordielektrikum 18 an den Wänden und am Grabenboden des Grabens 12 erzeugt.

Danach wird der Graben 12 mit einem elektrisch leitfähigen Elektrodenmaterial 20 gefüllt, beispielsweise mit hochdotiertem polykristallinen Silizium oder mit einem Metall. Nach dem Füllen des Grabens 12 wird planarisiert, wobei die Unterlageschicht 14 als Stoppschicht dient. Ein geeignetes Planarisierverfahren ist beispielsweise ein CMP-Verfahren (Chemisches Mechanisches Polieren) oder ein Ätzverfahren.

Wie auch in Figur 1A dargestellt, wird das Elektrodenmaterial 20 nach dem Planarisieren zurückgeätzt, beispielsweise um 250 nm unter die Oberfläche des Substrats 10.

Danach werden das Kondensatordielektrikum 18 und der Isolationskragen 17 im oberen Teil des Grabens 12 entfernt, beispielsweise mit Hilfe eines nass-chemischen Ätzverfahrens.

In einem nächsten Verfahrensschritt werden die Siliziumseitenwände im oberen Grabenbereich des Grabens 12 zur Aufbringung eines Transistordielektrikums vorbereitet, beispielsweise wird ein nass-chemischer Siliziumätzprozess und ein Reinigungsschritt ausgeführt. Optional lässt sich der Graben 12 in seinem oberen Bereich aufweiten, beispielsweise mit Hilfe einer Ätzung, die kristallrichtungsabhängig ist. Mit Hilfe der richtungsorientierten Ätzung lässt sich beispielsweise aus einem kreisrunden oder aus einem ovalen ein quadratischer oder rechteckiger Grabenquerschnitt mit kristallographisch glatten Seitenwänden im oberen Bereich des Grabens 12 erzielen.

Wie in Figur 1B gezeigt, wird anschließend ein dünnes einkristallines Gatedielektrikum 22 an den Seitenwänden des Grabens 12 und an dem freiliegenden Elektrodenmaterial 20 erzeugt, wobei ein Epitaxieverfahren angewendet wird. Im Ausführungsbeispiel besteht das Gatedielektrikum 22 aus Praseodymtrioxid Pr₂O₃. Beispielsweise wird eine Atomic Layer Deposition (ALD) oder ein anderes Epitaxieverfahren durchgeführt. Andere Abscheideverfahren sind z.B. Gasphasenepitaxie, metallorganische Gasphasenepitaxie oder Molekularstrahl-Epitaxie (MBA - Molecular Beam Epitaxy).

Es erfolgt ein optionaler Nachbehandlungsschritt, z.B. ein Ausheizschritt, bei dem Poren in dem Gatedielektrikum 22 verschlossen werden. Optional wird danach eine Schutzschicht auf das Gatedielektrikum 22 aufgebracht, beispielsweise eine Germaniumschutzschicht, die das Gatedielektrikum 22 an den Seitenwänden des Grabens 12 beim nächsten Verfahrensschritt schützt.

Danach wird das Gatedielektrikum 22 auf dem Elektrodenmaterial 20 entfernt, beispielsweise mit Hilfe eines anisotropen reaktiven Ionenätzens (RIE - Reactive Ion Etching). Danach wird die gegebenenfalls aufgebrachte Schutzschicht entfernt, beispielsweise nass-chemisch.

Wie ebenfalls in Figur 1B dargestellt, wird anschließend epitaktisch eine undotierte Silizium- oder Siliziumgermaniumschicht 24 auf das einkristalline Gatedielektrikum 22 aufgewachsen, beispielsweise in einer Dicke zwischen 5 nm bis 20 nm (Nanometer). Die Dicke der dabei erzeugten Siliziumschicht 24 wird so gewählt, dass der Kanal des zu erzeugenden Feldeffekttransistors immer verarmt ist, um sogenannte "Floating Body" - Effekte zu vermeiden. Außerdem gewährleistet eine dünne Siliziumschicht 24, dass keine Gitterfehler oder nur sehr wenige Gitterfehler entstehen.

Danach wird ein Ausdiffusionsschritt zur Herstellung eines Drainbereiches 25 an der Grenze von Siliziumschicht 24 und Elektrodenmaterial 20 durchgeführt, um den parallel zum Grabenboden des Grabens 12 liegenden Teil der Siliziumschicht 24 innerhalb des Grabens 12 zu dotieren. Bei diesem Schritt wird Dotierstoff aus dem Füllmaterial 20 in die Siliziumschicht 24 ausdiffundiert.

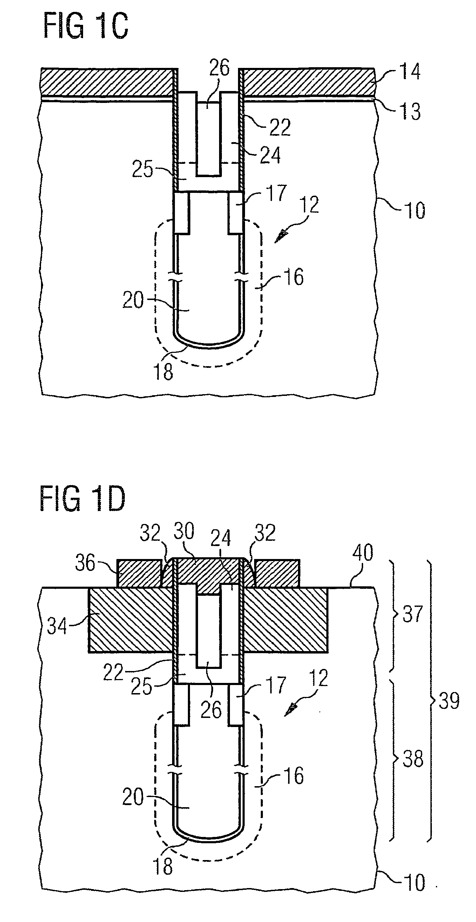

Wie in Figur 1C gezeigt, wird anschließend in den oberen Teil des Grabens 12 ein elektrisch isolierendes Isoliermaterial 26 eingebracht, beispielsweise Siliziumdioxid oder TEOS. Zum Einbringen des Isoliermaterials 26 wird beispielsweise ein HDP-Verfahren (High Density Plasma) eingesetzt. Das Isoliermaterial 26 und die Siliziumschicht 24 werden danach etwa bis zur Oberfläche des Substrats 10 zurückgeätzt, wobei das Gatedielektrikum 22 weiter an den Seitenflächen der Unterlagenschicht 14 verbleibt.

Anschließend wird ein Sourcekontakt 30 hergestellt, wobei elektrisch leitfähiges Material in den freiliegenden Teil des Grabens 12 eingebracht wird, beispielsweise hochdotiertes polykristallines Silizium oder Metall. Dieser Prozess kann selbstausrichtend durchgeführt werden. Anschließend wird planarisiert, beispielsweise mit Hilfe eines CMP-Verfahrens, wobei der Sourcekontakt 30 fertiggestellt wird, siehe Figur 1D. Die Unterlageschicht 14 und auch die Unterlageschicht 13 werden anschließend entfernt. In einem optionalen Verfahrensschritt werden anschließend an den Seiten der Sourceelektrode 30 Abstandselemente 32 gebildet, beispielsweise aus Siliziumdioxid oder aus Siliziumnitrid.

In einem nächsten Verfahrensschritt wird bspw. unter Verwendung einer fotolithografischen Maske ein Gatebereich 34 implantiert. Ein Gatekontakt 36 wird beispielsweise bei der Herstellung von Wortleitungen der Speicherschaltung hergestellt. Der Gatekontakt 36 besteht beispielsweise aus polykristallinem Silizium oder aus Metall. Der Gatebereich 34 ist in dem einkristallinen Substrat 10 angeordnet und beispielsweise stark n-dotiert. Somit entsteht ein Feldeffekttransistor 37 mit Trenchkondensator 38 als Teil einer Speicherzelle 39.

Bei einem anderen Ausführungsbeispiel wird der Feldeffekttransistor 37 in einem Graben ausgebildet, der keinen Grabenkondensator enthält. Bei einem weiteren Ausführungsbeispiel werden die Kanalanschlussbereiche 25, 30 innerhalb des Grabens 12 mit gleichem Abstand zu einer Oberfläche 40 des Substrats 10 angeordnet, so dass der Stromfluss im Kanal parallel zu der Oberfläche 40 des Substrats 10 gerichtet ist.

Bei einem weiteren Ausführungsbeispiel wird der Gatebereich 34 ebenfalls im Substrat 10 ausgebildet, jedoch in einem nicht von einem Graben durchdrungenen Bereich. Darüber wird das Transistordielektrikum und bspw. eine Siliziumschicht für den Kanalbereich abgeschieden. Mit Hilfe von fotolithografischen Verfahren werden anschließend die Kanalanschlussgebiete dotiert.

Als Transistordielektrikum 22 lassen sich auch andere Materialien verwenden, insbesondere Materialien mit einem relativen Dielektrizitätswert größer als 3,9 (Siliziumdioxid), d.h. sogenannte High-K-Materialien. Beispielsweise seien für diese Materialien noch genannt Hafniumdioxid (HfO₂) und Hafniumsiliziumoxynitrid (HfSiON).

Bei einem anderen Ausführungsbeispiel wird im Graben 12 bei ansonsten unveränderten Herstellungsschritten kein Isolationskragen 17 ausgebildet.

Durch die erläuterten Verfahren wird ein vertikaler Feldeffekttransistor angegeben, bei dem der Transistorkanal innerhalb eines Grabens angeordnet ist. Dies bietet zahlreiche Vorteile:
- die Dicke des Materials, in dem der Kanal ausgebildet wird, ist reduziert. Dadurch lässt sich die benötigte Fläche verkleinern,
- der Kanal des vertikalen Transistors befindet sich innerhalb des Grabens. Deshalb ist die Wechselwirkung mit anderen dicht benachbarten Transistoren gering.
- ein Isolationskragen und/oder eine horizontal verlaufende Isolierschicht in der Grabenmitte bzw. im oberen Bereich des Grabens kann entfallen. Außerdem fällt der in dem bekannten Stand der Technik erforderliche buried strap Anschluss fort. Dadurch lässt sich die Kapazität des Grabenkondensators vergrößern.
- eine einfache Prozessführung entsteht

## Patentansprüche

1. Feldeffekttransistor (37),
mit einem Kanalbereich (24),
mit einem ersten und zweiten an den Kanalbereich (24) angrenzenden elektrisch leitfähigen Kanalanschlussbereich (25, 30),
mit einem am Kanalbereich (24) angrenzenden Transistordielektrikum (22) und mit einem vom Kanalbereich (24) durch das Transistordielektrikum (22) getrennten Steuerbereich (34), mit einem Substrat (10), das den Steuerbereich (34) enthält und das eine Vielzahl von elektrischen Halbleiterbauelementen trägt,
einen in dem Substrat (10) angeordneten Graben (12), der das Transistordielektrikum (22) den ersten Kanalanschlussbereich (25) und den Kanalbereich (24) enthält,
wobei der Steuerbereich (34) an einer Grabenwand des Grabens (12) angeordnet ist,
**dadurch gekennzeichnet, dass** der Steuerbereich (34) aus einkristallinem Material gefertigt ist, und dass das Substrat ein einkristallines Substrat (10) ist, in dem der Steuerbereich (34) angeordnet ist.

2. Feldeffekttransistor (37) nach Anspruch 1, **dadurch gekennzeichnet, dass** der erste Kanalanschlussbereich (25) näher am Grabenboden des Grabens (12) als der zweite Kanalanschlussbereich (30) angeordnet ist.

3. Feldeffekttransistor (37) nach einem der vorhergehenden Ansprüche, **dadurch gekennzeichnet, dass** das einkristalline Material ein dotiertes Halbleitermaterial enthält.

4. Feldeffekttransistor (37) nach einem der vorhergehenden Ansprüche, **dadurch gekennzeichnet, dass** das einkristalline Material Silizium oder Siliziumgermanium enthält.

5. Feldeffekttransistor (37) nach einem der vorhergehenden Ansprüche, **dadurch gekennzeichnet, dass** das Transistordielektrikum (22) einkristallin ist,
wobei das Kristallgitter des Transistordielektrikums (22) vorzugsweise eine Gitterkonstante hat, die um weniger als 5 % von der Gitterkonstante des einkristallinen Materials abweicht.

6. Feldeffekttransistor (37) nach Anspruch 5, **dadurch gekennzeichnet, dass** das Transistordielektrikum (32) Praseodymoxid enthält oder aus Praseodymoxid besteht, insbesondere Praseodymtrioxid Pr₂O₃.

7. Feldeffekttransistor (37) nach einem der vorhergehenden Ansprüche, **dadurch gekennzeichnet, dass** der Kanalbereich (24) einkristallines Material enthält oder aus einkristallinem Material besteht,
und/oder dass der Kanalbereich (24) dotiert oder undotiert ist,
und/oder das der Kanalbereich (24) quer zum Steuerbereich (34) eine Ausdehnung kleiner als 20 nm hat.

8. Feldeffekttransistor (37) nach Anspruch 7, **dadurch gekennzeichnet, dass** der Kanalbereich (24) in einer Epitaxieschicht ausgebildet ist, die an das Transistordielektrikum (32) grenzt, vorzugsweise eine Siliziumepitaxieschicht oder eine Siliziumgermaniumepitaxieschicht.

9. Speicherzelle (38), **gekennzeichnet durch** einen Feldeffekttransistor (37) nach einem der vorhergehenden Ansprüche.

10. Speicherzelle (39) nach Anspruch 9, **dadurch gekennzeichnet, dass** der Graben (12) ein Kondensatordielektrikum (18) und eine Elektrode (20) eines Grabenkondensators (38) enthält.

11. Speicherzelle (39) nach Anspruch 10, **dadurch gekennzeichnet, dass** das Kondensatordielektrikum (18) und die Elektrode (20) in einem unteren Teil des Grabens (12) angeordnet sind,
und dass in einem oberen Teil des Grabens (12) das Transistordielektrikum (22) und der Kanalbereich (24) angeordnet sind.

12. Speicherzelle (39) nach Anspruch 11, **dadurch gekennzeichnet, dass** der Kanalbereich (24) entlang des Umfangs oder eines Teils des Umfangs des oberen Teils des Grabens (12) angeordnet ist,
und/oder dass der Kanalbereich (24) ein elektrisch isolierendes Füllmaterial (26) umschließt, das im oberen Teil des Grabens (12) angeordnet ist.

13. Speicherzelle (39) nach einem der Ansprüche 9 bis 12, **gekennzeichnet durch** einen Isolationskragen (17), der zwischen dem oberen Teil und dem unteren Teil des Grabens (12) angeordnet ist und der dicker als das Kondensatordielektrikum (18) ist, vorzugsweise mindestens dreimal so dick,
oder **dadurch**, dass zwischen dem unteren Teil des Grabens, (12) und dem oberen Teil des Grabens (12) kein Isolationskragen (17) angeordnet ist, der eine Dicke hat, die größer als die Dicke des Kondensatordielektrikums (18) oder des Transistordielektrikums (22) ist.

14. Speicherzelle (39) nach einem der Ansprüche 10 bis 13, **dadurch gekennzeichnet, dass** der erste Kanalanschlussbereich (25) innerhalb des Grabens (12) elektrisch leitfähig mit der Elektrode (20) verbunden ist.

15. Verfahren zur Herstellung eines Feldeffekttransistors (37) nach einem der Ansprüche 1 bis 8 oder zur Herstellung einer Speicherzelle (39) nach einem der Ansprüche 9 bis 14,
bei dem die folgenden Verfahrensschritte ausgeführt werden: in einem einkristallinen Substrat (10) Ausbilden eines Grabens (12) mit mindestens einem einkristallinen Bereich (10) des einkristallinen Substrats (10) an der Grabenwand und/oder am Grabenboden,
Erzeugen eines Dielektrikums (22) an dem einkristallinen Bereich,
Erzeugen eines ersten elektrisch leitfähigen Kanalanschlussbereiches (25) und eines Kanalbereichs (24) in dem Graben (12) nach dem Erzeugen des Dielektrikums (22),
Ausbildenden eines zweiten elektrisch leitfähigen Kanalanschlussbereiches (30),
Ausbilden eines Steuerbereich (34) in dem einkristallinen Bereich vor oder nach dem Ausbilden des Grabens (12).

16. Verfahren nach Anspruch 15, **dadurch gekennzeichnet, dass** ein einkristallines Dielektrikum (22) erzeugt wird, vorzugsweise durch epitaktisches Aufwachsen auf den einkristallinen Bereich (10), vorzugsweise mit Molekularstrahl-Epitaxie oder mit Gasphasenepitaxie oder mit Atomic Layer-Schichtabscheidung.

17. Verfahren nach Anspruch 15 oder 16, **dadurch gekennzeichnet, dass** ein einkristalliner Kanalbereich (24) erzeugt wird, vorzugsweise durch epitaktisches Aufwachsen auf das Dielektrikum (22), insbesondere durch Gasphasenabscheidung.

## Claims

1. Field effect transistor (37)
having a channel region (24),
having a first and second electrically conductive channel connection region (25, 30), adjoining the channel region (24),
having a transistor dielectric (22) adjoining the channel region (24), and having a control region (34) separated from the channel region (24) by the transistor dielectric (22),
having a substrate (10), which contains the control region (34) and which carries a multiplicity of electrical semiconductor components,
a trench (12) arranged in the substrate (10), which trench contains the transistor dielectric (22), the first channel connection region (25) and the channel region (24),
the control region (34) being arranged at a trench wall of the trench (12),
**characterized in that** the control region (34) is fabricated from monocrystalline material, and
**in that** the substrate is a monocrystalline substrate (10), in which the control region (34) is arranged.

2. Field effect transistor (37) as claimed in claim 1, **characterized in that**
the first channel connection region (25) is arranged closer to the trench bottom of the trench (12) than the second channel connection region (30).

3. Field effect transistor (37) according to one of the preceding claims, **characterized in that** the monocrystalline material contains a doped semiconductor material.

4. Field effect transistor (37) as claimed in one of the preceding claims, **characterized in that** the monocrystalline material contains silicon or silicon-germanium.

5. Field effect transistor (37) as claimed in one of the preceding claims, **characterized in that** the transistor dielectric (22) is monocrystalline,
the crystal lattice of the transistor dielectric (22) preferably having a lattice constant that deviates by less than 5% from the lattice constant of the monocrystalline material.

6. Field effect transistor (37) as claimed in Claim 5, **characterized in that** the transistor dielectric (32) contains praseodymium oxide or comprises praseodymium oxide, in particular praseodymium trioxide Pr₂O₃.

7. Field effect transistor (37) as claimed in one of the preceding claims, **characterized in that** the channel region (24) contains monocrystalline material or comprises monocrystalline material,
and/or **in that** the channel region (24) is doped or undoped,
and/or **in that** the channel region (24) has an extent of less than 20 nm transversely with respect to the control region (34).

8. Field effect transistor (37) as claimed in Claim 7, **characterized in that** the channel region (24) is formed in an epitaxial layer adjoining the transistor dielectric (32), preferably a silicon epitaxial layer or a silicon-germanium epitaxial layer.

9. Memory cell (38) **characterized by** a field effect transistor (37) as claimed in one of the preceding claims.

10. Memory cell (39) as claimed in Claim 9,
**characterized in that** the trench (12) contains a capacitor dielectric (18) and an electrode (20) of a trench capacitor (38).

11. Memory cell (39) as claimed in Claim 10,
**characterized in that** the capacitor dielectric (18) and the electrode (20) are arranged in a lower part of the trench (12),
and **in that** the transistor dielectric (22) and the channel region (24) are arranged in an upper part of the trench (12).

12. Memory cell (39) as claimed in Claim 11,
**characterized in that** the channel region (24) is arranged along the periphery or a part of the periphery of the upper part of the trench (12),
and/or **in that** the channel region (24) encloses an electrically insulating filling material (26) arranged in the upper part of the trench (12).

13. Memory cell (39) as claimed in one of Claims 9 to 12, **characterized by** an insulation collar (17), which is arranged between the upper part and the lower part of the trench (12) and is thicker than the capacitor dielectric (18), preferably at least three times as thick,
or in that no insulation collar (17) having a thickness that is greater than the thickness of the capacitor dielectric (18) or of the transistor dielectric (22) is arranged between the lower part of the trench (12) and the upper part of the trench (12).

14. Memory cell (39) as claimed in one of Claims 10 to 13, **characterized in that** the first channel connection region (25) within the trench (12) is electrically conductively connected to the electrode (20).

15. Method for producing a field effect transistor (37) as claimed in one of Claims 1 to 8, or for producing a memory cell (39) as claimed in one of Claims 9 to 14,
in which the following method steps are performed:
in a monocrystalline substrate (10) formation of a trench (12) with at least one monocrystalline region (10) of the monocrystalline substrate (10) at the trench wall and/or at the trench bottom,
production of a dielectric (22) at the monocrystalline region,
production of a first electrically conductive channel connection region (25) and of a channel region (24) in the trench (12) after the production of the dielectric (22),
formation of a second electrically conductive channel connection region (30),
formation of a control region (34) in the monocrystalline region before or after the formation of the trench (12).

16. Method as claimed in Claim 15, **characterized in that** a monocrystalline dielectric (22) is produced, preferably by epitaxial growth on the monocrystalline region (10), preferably by means of molecular beam epitaxy or by means of vapour phase epitaxy or by means of atomic layer deposition.

17. Method as claimed in Claim 15 or 16, **characterized in that** a monocrystalline channel region (24) is produced, preferably by epitaxial growth on the dielectric (22), in particular by vapour phase deposition.

## Revendications

1. Transistor (37) à effet de champ,
comprenant une zone (24) de canal,
comprenant une première et une deuxième zone (25, 30) de borne de canal, conductrice de l'électricité et voisine de la zone (24) de canal,
comprenant un diélectrique (22) de transistor voisin de la zone (24) de canal et comprenant une zone (34) de commande séparée de la zone (24) de canal par le diélectrique (22) de transistor,
comprenant un substrat (10) qui comporte la zone (34) de commande et qui porte une pluralité de composants électriques à semi-conducteurs,
comprenant un sillon (12) ménagé dans le substrat (10) et contenant le diélectrique (22) de transistor, la première zone (25) de borne de canal et la zone (24) de canal,
la zone (34) de commande étant disposée sur une paroi du sillon (12),
**caractérisé en ce que** la zone (34) de commande est en un matériau monocristallin, et
**en ce que** le substrat est un substrat (10) monocristallin dans lequel est disposé la zone (34) de commande.

2. Transistor (37) à effet de champ suivant la revendication 1, **caractérisé en ce que** la première zone (25) de borne de canal est disposée plus près du fond du sillon (12) que la deuxième zone (30) de borne de canal.

3. Transistor (37) à effet de champ suivant l'une des revendications précédentes, **caractérisé en ce que** le matériau monocristallin contient un matériau semi-conducteur dopé.

4. Transistor (37) à effet de champ suivant l'une des revendications précédentes, **caractérisé en ce que** le matériau monocristallin contient du silicium ou du silicium germanium.

5. Transistor (37) à effet de champ suivant l'une des revendications précédentes, **caractérisé en ce que** le diélectrique (22) de transistor est monocristallin, le réseau cristallin du diélectrique (22) de transistor ayant de préférence une constante de réseau qui s'écarte de moins de 5 % de la constante du réseau du matériau monocristallin.

6. Transistor (37) à effet de champ suivant la revendication 5, **caractérisé en ce que** le diélectrique (32) de transistor contient de l'oxyde de praséodyme ou est en oxyde de praséodyme, notamment en trioxyde de praséodyme Pr₂O₃.

7. Transistor (37) à effet de champ suivant l'une des revendications précédentes, **caractérisé en ce que** la zone (24) de canal contient du matériau monocristallin ou est en matériau monocristallin,
et/ou **en ce que** la zone (24) de canal est dopée ou ne l'est pas,
et/ou **en ce que** la zone (24) de canal a, transversalement à la zone (34) de commande, une étendue plus petite que 20 nm.

8. Transistor (37) à effet de champ suivant la revendication 7, **caractérisé en ce que** la zone (24) de canal est formée dans une couche d'épitaxie qui est voisine du diélectrique (32) de transistor, de préférence une couche d'épitaxie au silicium ou une couche d'épitaxie au silicium germanium.

9. Cellule (38) de mémoire **caractérisée par** un transistor (37) à effet de champ suivant l'une des revendications précédentes.

10. Cellule (39) de mémoire suivant la revendication 9, **caractérisée en ce que** le sillon (12) contient un diélectrique (18) de condensateur et une électrode (20) d'un condensateur (38) à sillon.

11. Cellule (39) de mémoire suivant la revendication 10, **caractérisée en ce que** le diélectrique (18) de condensateur et l'électrode (20) sont disposés dans une partie inférieure du sillon 12,
et **en ce que** le diélectrique (22) du transistor et la zone (24) de canal sont disposés dans une partie supérieure du sillon (12).

12. Cellule (39) de mémoire suivant la revendication 11, **caractérisée en ce que** la zone (24) de canal est disposée le long du pourtour ou d'une partie du pourtour de la partie supérieure du sillon (12),
et/ou **en ce que** la zone (24) de canal entoure une matière (26) de remplissage isolante du point de vue électrique, qui est disposée dans la partie supérieure du sillon (12).

13. Cellule (39) de mémoire suivant l'une des revendications 9 à 12, **caractérisée par** un collet (17) isolant qui est disposé entre la partie supérieure et la partie inférieure du sillon (12) et qui est plus épais que le diélectrique (18) du condensateur, de préférence au moins trois fois aussi épais,
ou **caractérisée en ce qu'**il n'y a pas, entre la partie inférieure du sillon (12) et la partie supérieure du sillon (12), de collet (17) isolant ayant une épaisseur qui est plus grande que l'épaisseur du diélectrique (18) du condensateur ou du diélectrique (22) de transistor.

14. Cellule (39) de mémoire suivant l'une des revendications 10 à 13, **caractérisée en ce que** la première zone (25) de borne de canal est reliée à l'intérieur du sillon (22) d'une manière conductrice d'électricité à l'électrode (20) .

15. Procédé de production d'un transistor (37) à effet de champ suivant l'une des revendications 1 à 8 ou de production d'une cellule (39) de mémoire suivant l'une des revendications 9 à 14,
dans lequel on effectue les stades de procédé suivants :
on forme dans un substrat (10) monocristallin un sillon (12) avec au moins une zone (10) monocristalline du substrat (10) monocristallin sur la paroi d'un sillon et/ou au fond d'un sillon,
on produit un diélectrique (22) sur la partie monocristalline,
on produit une première zone (25) conductrice de l'électricité de borne de canal d'une zone (24) de canal dans le sillon (12) après la production du diélectrique (22),
on forme une deuxième zone (30) de borne de canal conductrice de l'électricité,
on forme une zone (34) de commande dans la zone monocristalline avant ou après la formation du sillon (12).

16. Procédé suivant la revendication 15, **caractérisé en ce que** l'on produit un diélectrique (22) monocristallin, de préférence par croissance par épitaxie sur la zone (10) monocristalline, de préférence par épitaxie à faisceau moléculaire ou par épitaxie en phase gazeuse ou par dépôt de couche atomique.

17. Procédé suivant la revendication 15 ou 16, **caractérisé en ce que** l'on produit une zone (24) de canal monocristalline, de préférence par croissance par épitaxie sur le diélectrique (22), notamment par dépôt en phase gazeuse.
